# EUROPÄISCHE PATENTSCHRIFT

(11) **EP 0 727 670 B1**
(45) Veröffentlichungstag und Bekanntmachung des Hinweises auf die Patenterteilung: **22.11.2006**
(21) Anmeldenummer: 96101354.7
(22) Anmeldetag: 31.01.1996
(51) Int. Cl.: G01R 25/00, G01R 25/08

(54) **Schaltungsanordnung zur Phasendifferenzmessung**
Phase difference measuring circuit
Circuit de mesure de différence de phase

(30) Priorität: 17.02.1995 DE 19506007
(43) Veröffentlichungstag der Anmeldung: 21.08.1996
(73) Patentinhaber: Infineon Technologies AG, 81669 München (DE)
(72) Erfinder: Kramer, Ronalf, Dipl.-Ing., D-81247 München (DE)
(74) Vertreter: Reinhard - Skuhra - Weise & Partner

(56) Entgegenhaltungen:
- US-A- 4 704 574

## Beschreibung

Die Erfindung betrifft eine Schaltungsanordnung zur Messung der Phasendifferenz zwischen einem Referenzsignal und einem Taktsignal.

Digitale Schaltungsanordnungen zur Phasendifferenzmessung - auch digitale Phasendetektoren genannt- sind in vielfältigen Ausführungsformen bekannt. Eine Ausführungsform ist beispielsweise in U.Tietze, Ch.Schenk, Electronic Circuits-Design and Applications, Berlin, Heidelberg 1991, Seite 869f beschrieben. Derartige Schaltungsanordnungen vergleichen im allgemeinen ein Referenzsignal und ein Taktsignal miteinander und erzeugt ein der Phasendifferenz beider Signale entsprechendes Binärwort. Die Phasenauflösung ist dabei nicht höher als die Periodendauer des höherfrequenteren der beiden Signale, in der Regel die Periodendauer des Taktsignals.

Eine weitere Schaltungsanordnung zur Phasendifferenzmessung wird in US-A-4704574 beschrieben. Dabei findet eine Grob- und eine Feinmessung anhand von Zählerbausteinen statt.

Aufgabe der Erfindung ist es, eine Schaltungsanordnung der eingangs genannten Art mit höherer Phasenauflösung anzugeben.

Die Aufgabe wird gelöst durch eine Schaltungsanordnung mit einem ersten Schieberegister, an dessen Eingang das Referenzsignal angelegt ist und das durch das Taktsignal getaktet wird,
mit einem digitalen Differenzierer, der dem ersten Schieberegister nachgeschaltet ist,
mit einem Zähler, an dessen Eingang das Taktsignal angelegt ist und der ein mehrstelliges Binärwort abgibt, mit einem Zwischenspeicher, der mit dem Zähler und dem digitalen Differenzierer verbunden ist und der bei Auftreten eines entsprechenden Ausgangssignals des digitalen Differenzierers das Binärwort am Ausgang des Zählers speichert, mit einem zweiten

Schieberegister, an dessen Eingang das Referenzsignal angelegt ist und das durch das Taktsignal invers getaktet wird, mit einem analogen Differenzierer, dessen Eingang mit dem Ausgang des digitalen Differenzierers verbunden ist,
mit einem D-Flip-Flop, dessen Dateneingang mit dem Ausgang des zweiten Schieberegisters und dessen Takteingang mit dem Ausgang des analogen Differenzierers verbunden ist und dessen Ausgangssignal die niederwertigste Stelle eines Ausgangsbinärwortes bildet, wobei die höherwertigen Stellen des Ausgangsbinärwortes durch das am Ausgang des Zwischenspeichers bereitstehende Binärwort gegeben sind.

Die Erfindung wird nachfolgend anhand des in den beiden Figuren der Zeichnung dargestellten Ausführungsbeispiels näher erläutert. Es zeigt:
- Figur 1: das Blockdiagramm einer erfindungsgemäßen Schaltungsanordnung und
- Figur 2: den Signalverlauf bei einer erfindungsgemäßen Schaltungsanordnung in einem Diagramm.

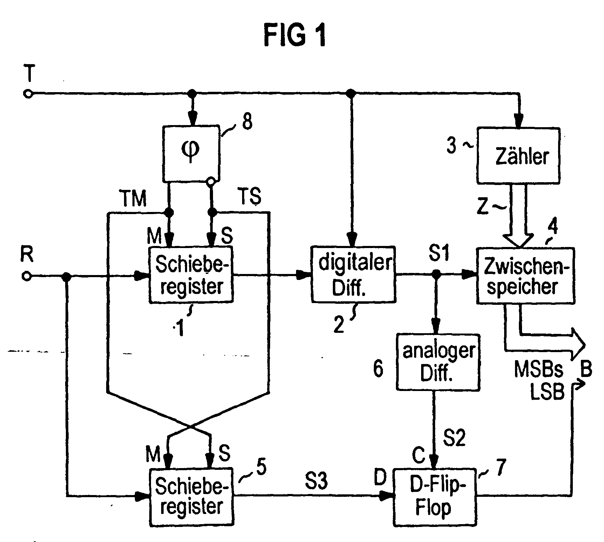

Bei dem Ausführungsbeispiel nach Figur 1 ist ein Referenzsignal R an den Eingang eines Schieberegisters 1 angelegt. Das Schieberegister 1 wird durch einen Mastertakt TM und einen Slavetakt TS getaktet, die jeweils an einen Mastertakteingang M und Slavetakteingang S angelegt sind. Mastertakt TM und Slavetakt TS haben gleiche Frequenz, sind jedoch zueinander um 180° phasenverschoben und überlappen sich nicht. Sie gehen beide aus einem Takt T hervor, der ebenfalls die selbe Frequenz hat und mittels der Taktaufbereitungseinrichtung 8 in den Mastertakt TM und den Slavetakt TS aufgespalten wird.

Dem Schieberegister 1 ist ein digitaler Differenzierer 2 nachgeschaltet, der beispielsweise aus einem Verzögerungselement besteht, wobei Eingangssignal und Ausgangssignal des Verzögerungselementes über ein UND-Gatter miteinander verknüpft werden. Darüber hinaus wird der digitale Differenzierer 2 bevorzugt durch den Takt T getaktet, indem beispielsweise das UND-Gatter zur Verknüpfung von Eingangs- und Ausgangssignal des Verzögerungselements einen dritten Eingang aufweist, an den der Takt T angelegt ist. Am Ausgang des digitalen Differenzierers 2 steht ein Signal S1 bereit.

Ein durch das Taktsignal T angesteuerter Zähler 3 zählt fortlaufend von Null bis zu seinem maximalen Zählerstand, um anschließend wieder bei Null zu beginnen. Dabei werden alle Binärworte von Null bis zum Maximalwert durchlaufen.

Der Ausgang des Zählers 3 ist auf den Eingang eines Zwischenspeichers 4 geführt, der bei Auftreten des entsprechenden Signales S1 das am Ausgang des Zählers 3 aktuell anliegende Binärwort Z übernimmt und so lange speichert, bis eine erneute Übernahme erfolgt. Das jeweils im Zwischenspeicher 4 befindliche Binärwort ist am Ausgang des Zwischenspeichers 4 abnehmbar und bildet die höherwertigen Stellen MSBs eines die Phasendifferenz zwischen Referenzsignal R und Taktsignal T angebenden Ausgangsbinärworts B.

Darüber hinaus ist ein weiteres, invers getaktetes Schieberegister 5-vorgesehen, an dessen Eingang ebenfalls das Referenzsignal R angelegt ist. Dabei wird zur inversen Taktung der Mastertakteingang M mit dem Slavetakt TS und der Slavetakteinang S mit dem Mastertakt TM angesteuert. An den Ausgang des Schieberegisters 5, der ein Signal S3 führt, ist der Dateneingang eines D-Flip-Flops 7 angeschlossen, an dessen Takteingang C ein Signal S2 anliegt. Der Ausgang des D-Flip-Flops 7 bildet das niederwertigste Bit des Ausgangsdatenwortes B.

Das Signal S2 wird durch einen analogen Differenzierer 6 erzeugt, an dessen Eingang das Signal S1 geführt ist. Der analoge Differenzierer 6 kann beispielsweise aus einer Kette von hintereinander geschalteten Gattern bestehen, wobei Ausgangssignal und Eingangssignal der Kette über UND-Gatter miteinander verknüpft werden.

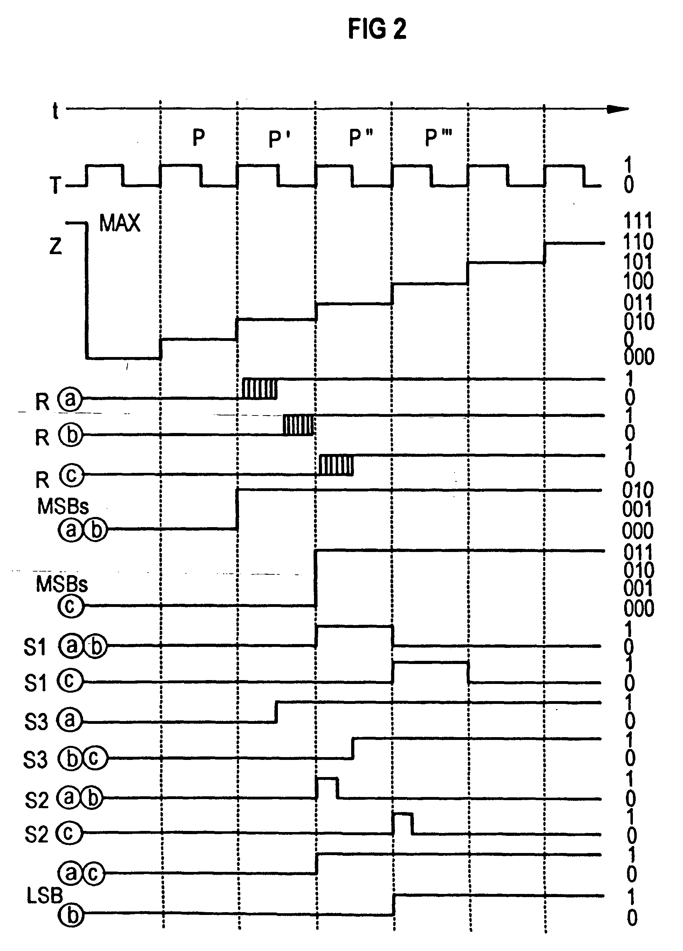

In Figur 2 der Zeichnung sind über der Zeit t die Verläufe der Signale T, Z, MSBs, S1, S2, S3, LSB für drei verschiedene Phasenlagen des Referenzsignals R. Die drei Fälle sind in der Zeichnung mit a, b und c bezeichnet. Das Zeitraster wird durch die Periode P des Taktsignals T vorgegeben. Aus dem Taktsignal sind der Mastertakt TM und der Slavetakt TS abgeleitet, wobei beide sich an den Flanken nicht überlappen.

Entsprechend den zu unterscheidenden Phasenlagen a), b) und c) tritt die Flanke des Referenzsignals R im Fall a) in der ersten Hälfte einer bestimmten Taktperiode P', im Fall b) in der zweiten Hälfte dieser Taktperiode P' und im Fall c) in der ersten Hälfte der darauffolgenden Taktperiode P" auf. Demnach wird zu verschiedenen Zeitpunkten der Zählerstand Z, der über der Zeit t als Treppenfunktion zwischen Null und einem maximalen Binärwert MAX mit einer der Periode P entsprechenden Schrittweise dargestellt werden kann, in den Zwischenspeicher 4 übernommen. Das bedeutet, daß den Fällen a) und b) der Zählerstand Z während der ersten Taktperiode P' übernommen wird und im Fall c) in der darauffolgenden Taktperiode P". Demzufolge unterscheiden sich die höherwertigen Bits MSBs des Ausgangsbinärwortes B um eine Stelle in dem Fall c) gegenüber den Fällen a) und b).

Beim Signal S1 am Ausgang des digitalen Differenzierers 2 tritt in den Fällen a) und b) folglich ein Impuls mit der Breite P während der Periode P" und im Fall c) in der darauffolgenden Periode P"' auf. Aufgrund der inversen Taktung des Schieberegisters 5 tritt dagegen eine ansteigende Flanke beim Signal S3 im Fall a) bereits bei der halben Periode P' und in den anderen beiden Fällen b) und c) bei der Hälfte der darauffolgenden Periode P" auf. Da nun das Signal S2 aus der positiven Flanke des Signals S1 hergeleitet wird und aufgrund der analogen Differenzierung mittels des analogen Differenzierers 6 eine kürzere Impulsdauer aufweist, erfolgt die Übernahme des augenblicklichen Wertes des Signals S3 in den Fällen a) und b) zu Beginn der Periode P" und im Fall c) zu Beginn der Periode P"'. Im Fall a) ist bis zum Übernahmezeitpunkt zu Beginn der Periode P'' das Signal S3 gleich Eins und im Fall b) gleich Null. Im Fall c) ist zum Übernahmezeitpunkt zu Beginn der Periode P"' das Signal S3 gleich Eins. Folglich ist die am Ausgang des D-Flip-Flops 7 bereitstehende niederwertigste Stelle LSB des Ausgangsbinärwortes B im Fall a) gleich Eins, im Fall b) gleich Null und im Fall c) wiederum gleich Eins.

Da der zeitliche Abstand zwischen den Fällen a), b) und c) jedoch nur die Hälfte der Periodendauer P beträgt, ist die Auflösung der erfindungsgemäßen Schaltungsanordnung zur Messung einer Phasendifferenz doppelt so hoch als die Periodendauer P des Taktsignals T, also gleich P/2.

## Patentansprüche

1. Schaltungsanordnung zur Messung der Phasendifferenz zwischen einem Referenzsignal (R) und einem Taktsignal (T), **gekennzeichnet durch** folgende Merkmale:
einem ersten Schieberegister (1), an dessen Eingang das Referenzsignal (R) angelegt ist und das **durch** das Taktsignal (T) getaktet wird,
einem digitalen Differenzierer (2), der dem ersten Schieberegister (1) nachgeschaltet ist,
einem Zähler (3), an dessen Eingang das Taktsignal (T) angelegt ist und der ein mehrstelliges Binärwort (Z) abgibt,
einem Zwischenspeicher (4), der mit dem Zähler (3) und dem digitalen Differenzierer (2) verbunden ist und der bei Auftreten eines entsprechenden Ausgangssignals (S1) des digitalen Differenzierers (2) das Binärwort (Z) am Ausgang des Zählers (3) speichert,
einem zweiten Schieberegister (5), an dessen Eingang das Referenzsignal (R) angelegt ist und das **durch** das Taktsignal (T) invers getaktet wird,
einem analogen Differenzierer (6), dessen Eingang mit dem Ausgang des digitalen Differenzierers (2) verbunden ist,
einem D-Flip-Flop (7), dessen Dateneingang (D) mit dem Ausgang des zweiten Schieberegisters (5) und dessen Takteingang (C) mit dem Ausgang des analogen Differenzierers (6) verbunden ist und dessen Ausgangssignal die niederwertigste Stelle (LSB) eines Ausgangsbinärwortes (B) bildet, wobei die höherwertigen Stellen (MSBs) des Ausgangsbinärwortes (B) durch das am Ausgang des Zwischenspeichers (4) bereitstehende Binärwort gegeben sind.

## Claims

1. Circuit arrangement for measuring the phase difference between a reference signal (R) and a clock signal (T), **characterized by** the following features:
a first shift register (1) whose input has the reference signal (R) applied to it and which is clocked using the clock signal (T),
a digital differentiator (2) which is connected downstream of the first shift register (1),
a counter (3) whose input has the clock signal (T) applied to it and which outputs a multidigit binary word (Z),
a buffer memory (4) which is connected to the counter (3) and to the digital differentiator (2) and which, when a corresponding output signal (S1) from the digital differentiator (2) occurs, stores the binary word (Z) at the output of the counter (3),
a second shift register (5) whose input has the reference signal (R) applied to it and which is inversely clocked using the clock signal (T),
an analogue differentiator (6) whose input is connected to the output of the digital differentiator (2),
a D-type flip-flop (7) whose data input (D) is connected to the output of the second shift register (5) and whose clock input (C) is connected to the output of the analogue differentiator (6) and whose output signal forms the least significant place (LSB) of an output binary word (B), the more significant places (MSBs) of the output binary word (B) being provided by the binary word which is ready at the output of the buffer memory (4).

## Revendications

1. Agencement de circuits pour mesurer la différence de phase entre un signal de référence (R) et un signal de synchronisation (T), **caractérisé par** les caractéristiques suivantes :
- un premier registre à décalage (1), à l'entrée duquel le signal de référence (R) est appliqué et qui est synchronisé par le signal de synchronisation (T)
- un différenciateur numérique (2), qui est monté en aval du premier registre à décalage (1),
- un compteur (3), à l'entrée duquel le signal de synchronisation (T) est appliqué et qui délivre un mot binaire (Z) à plusieurs positions,
- une mémoire intermédiaire (4) qui est reliée avec le compteur (3) et le différenciateur numérique (2) et qui à la production d'un signal de sortie (S1) correspondant du différenciateur numérique (2) mémorise le mot binaire (Z) à la sortie du compteur (3),
- un deuxième registre à décalage (5), à l'entrée duquel le signal de référence (R) est appliqué et qui est soumis à une synchronisation inverse par le signal de synchronisation (T),
- un différenciateur analogique (6), dont l'entrée est reliée à la sortie du différenciateur numérique (2),
- une bascule D (7), dont l'entrée de données (D) est reliée à la sortie du deuxième registre à décalage (5) et dont l'entrée de synchronisation (C) est reliée à la sortie du différenciateur analogique (6) et dont le signal de sortie forme la position de moindre valeur (LSB) d'un mot binaire de sortie (B), les positions de plus fortes valeurs (MSB) du mot binaire de sortie (B) étant données par le mot binaire disponible à la sortie de la mémoire intermédiaire (4).
